# EUROPÄISCHE PATENTANMELDUNG

(11) **EP 0 940 718 A2**
(43) Veröffentlichungstag der Anmeldung: **08.09.1999**
(21) Anmeldenummer: 99102323.5
(22) Anmeldetag: 06.02.1999
(51) Int. Cl.: G03F 1/14

(54) **Retikel mit Kristall-Trägermaterial und Pellicle**

(30) Priorität: 02.03.1998 DE 19808461
(71) Anmelder: Carl Zeiss, 89518 Heidenheim (Brenz) (DE); Carl-Zeiss-Stiftung trading as Carl Zeiss, 89518 Heidenheim (Brenz) (DE)
(72) Erfinder: Schuster, Karl-Heinz, 89551 Königsbronn (DE); Wagner, Christian Dr., 73431 Aalen (DE)

(57) **Zusammenfassung**

Belichtungsanlage der Mikrolithographie mit einem Beleuchtungssystem (2) und einem Retikel (1) mit Magnesiumfluorid als Trägermaterial (10), wobei das Beleuchtungssystem (2) radial polarisiertes Licht (20, P_{L}, P_{R}) bereitstellt und das Magnesiumfluorid mit seiner Kristall-Hauptachse nahezu in Richtung der optischen Achse (A) am Retikel (1) orientiert ist. Zudem wird eine geeignete Kühlung (5, 13, 14, 50, 51, 52) angegeben.

## Beschreibung

Die Erfindung betrifft ein Retikel, dessen transparentes Trägermaterial aus einem optisch einachsigen Kristall besteht.

In DE 34 17 888 A ist ein Retikel für 100-200 nm Lithographie beschrieben, dessen Substrat aus MgF₂ gleichrangig wie aus CaF₂ oder diversen anderen Fluoriden bestehen soll. Offenbar ist nur deren Transparenz im angegebenen Wellenlängenbereich als Auswahlkriterium beachtet. Zur Kristallstruktur, Doppelbrechung, Wärmeausdehnung und Polarisation ist nichts ausgesagt.

In der technischen Publikation TP 58401 ist die 157 nm-Lithographie mit transparenten optischen Elementen u.a. aus MgF₂ ohne nähere Spezifikation beschrieben.

MgF₂ ist ein typischer optisch einachsiger Kristall.

In der DE 195 35 392 A ist eine radial polarisationsdrehende optische Anordnung und eine Mikrolithographie-Projektionsbelichtungsanlage damit beschrieben.

Die Lithographie mit der Excimer-Laser-Wellenlänge 157 nm kann nicht mehr auf das bewährte Quarzglas als Retikel-Trägermaterial zurückgreifen, da dies im angegebenen Spektralbereich undurchlässig ist. Das isotrope CaF₂ hat einen drastisch höheren linearen Wärmeausdehnungskoeffizienten von 18,9 · 10⁻⁶/K gegenüber 0,5 · 10⁻⁶/K von Quarzglas.

Das schon vorgeschlagene MgF₂ (Magnesiumfluorid) hat eine deutlich kleinere Wärmeausdehnung. Aufgrund der Kristallstruktur ist dieser Kristall aber nicht nur optisch einachsig doppelbrechend, sondern auch die Wärmeausdehnung ist anisotrop.

Pellicles sind dünne Membranen zum Schutz der Maskenstruktur auf dem Retikel. Neben organischen Folien sind z.B. auch SiO₂-Pellicles bekannt. JP 4-081756 A gibt ein Pellicle an, bei dem ein Fluoropolymer beidseitig mit CaF₂ beschichtet ist.

Aufgabe der Erfindung ist es, ein Retikel anzugeben, das für Wellenlängen im Bereich 100-200 nm geeignet ist und hinsichtlich seiner thermischen und optischen Eigenschaften verbessert ist. Gleiches gilt für ein erfindungsgemäßes Pellicle.

Gelöst wird die Aufgabe durch ein Retikel nach einem der Ansprüche 1 oder 2. Demnach wird die Achsrichtung des kristallinen Trägers so ausgerichtet, daß die thermische Ausdehnung innerhalb der Retikel-Fläche homogen ist. Bei genau senkrechter Orientierung der Kristallachse gelingt dies ideal. Abweichungen, die z.B. fertigungstechnisch bedingt sind, können aber in dem Maße toleriert werden, wie die damit zunehmende ungleichmäßige Wärmeausdehnung toleriert werden kann. Die in Anspruch 3 angegebenen Toleranz von 5° stellt ein Maß dar, oberhalb dessen die Ausführung wenig sinnvoll wird.

MgF₂ ist das bevorzugte optisch einachsige Kristall-Material.

Durch eine Kühlvorrichtung gemäß den Unteransprüchen 4 bis 5 kann die Störung der mikrolithographischen Abbildung durch die Wärmeausdehnung des Retikels zusätzlich reduziert werden.

Eine Optimierung auch der optischen Eigenschaften ergibt sich durch die Einbindung des so ausgebildeten Retikels in eine Belichtungsanlage mit einem Beleuchtungssystem, das radial polarisiertes Licht bereit stellt, gemäß Anspruch 6 oder 7. Damit wird auch die Brechung am Kristall nicht mehr richtungsabhängig. Für die Toleranz gegen Abweichungen der optischen Achse von der Kristallachse gilt das obengesagte entsprechend, daher ergeben sich vorteilhafte Weiterbildungen gemäß Anspruch 8 durch Aufnahme der Merkmale der Ansprüche 3 bis 5.

Damit wird also eine Belichtungsanlage mit einem bei 100-200 nm Lichtwellenlänge transparenten Retikel ausgestattet, bei dem Anisotropien der Wärmeausdehnung und der Lichtbrechung keine Rolle spielen und der Absolutbetrag der Wärmeausdehnung gegenüber CaF₂ (9,4 · 10⁻⁶/K) als dem gangbarsten Vergleichsmaterial halbiert ist.

Eine weitere erfindungsgemäße Ausführung des Retikels ist in den Ansprüchen 9 bis 11 beschrieben, wo eine Problemlösung durch eine geeignete Kühlung angegeben wird.

Anspruch 12 gibt die erfindungsgemäße Ausführung eines Pellicles an, das aus Fluoridkristall, vorzugsweise CaF₂ oder BaF₂ bzw. MgF, besteht.

Näher erläutert wird die Erfindung anhand des in der Zeichnung dargestellten Beispiels.

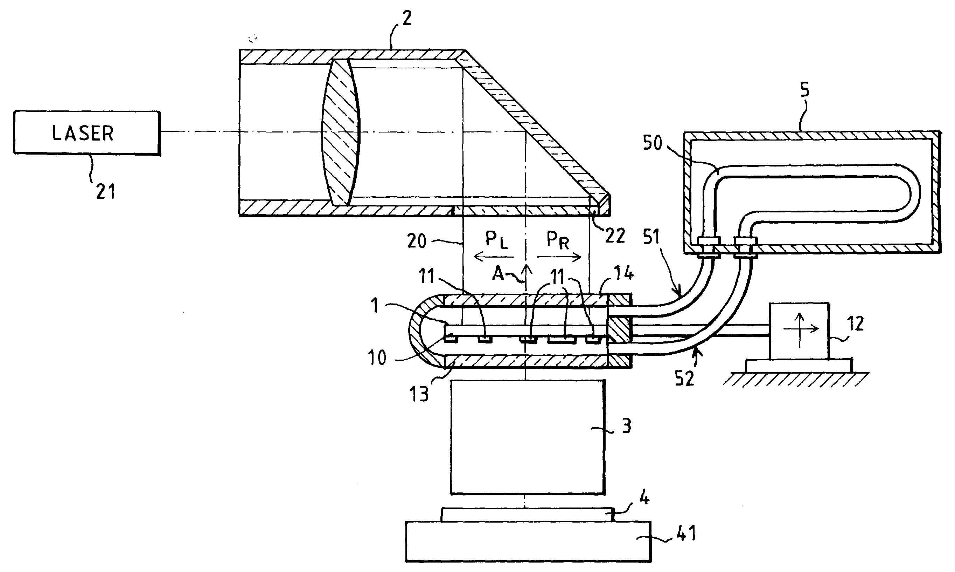

- Figur 1: zeigt schematisch eine Projektionsbelichtungsanlage der erfindungsgemäßen Art.

Ein DUV-Excimer-Laser 21 mit z.B. 157 nm Wellenlänge bildet mit einer Optik 2 ein Beleuchtungssystem, das mit einem Radial-Polarisator 22 nach DE 195 35 392 A ergänzt ist. Damit wird ein Lichtbündel 20 mit radialer Polarisation - durch die Vektoren P_{L} und P_{R} angedeutet - und der optischen Achse A erzeugt.

Dieses durchstrahlt ein Retikel 1 mit nicht transmittierenden Strukturen 11, z.B. aus Chrom, auf dem transparenten Träger 10. Dieser ist hier aus M_{g}F₂ gebildet mit einer Orientierung der Hauptachse in Richtung der optischen Achse A. Die Strukturen 11 werden dann durch das Projektionsobjektiv 3, z.B. ein Spiegelobjektiv, auf den Wafer 4 abgebildet, der auf einer Trageinrichtung 41 positioniert ist. Die Strukturen 11 sind auf der dem Projektionsobjektiv 3 zugewandten Seite des Trägers 10 angeordnet, da dann das Trägermaterial 10 nicht im eigentlichen Abbildungsstrahlengang angeordnet ist. Das Retikel 1 ist an einer Positioniereinrichtung 12 befestigt.

Das Retikel 1 ist zwischen zwei planparallelen Deckplatten (Pellicles) 13, 14 aus Material geeigneter Transparenz, z.B. CaF₂, BaF₂ oder aus gleich orientiertem MgF₂, angeordnet, welche mit einem Leitungssystem 51, 52 und einem Kühlsystem 5 verbunden sind. Dadurch kann das Retikel 1 von einem Fluid 50, vorzugsweise einem Gas und zwar am geeignetsten Helium, umspült werden. Damit wird ein wirkungsvoller Temperaturausgleich zwischen unterschiedlich mit Struktur 11 belegten oder unterschiedlich intensiv vom Lichtbündel 20 bestrahlten Bereichen des Retikels 1 sowie insgesamt eine Kühlung und Temperaturstabilisierung ermöglicht. Vorzugsweise wird eine Gegenstromkühlung der Vorder- und Rückseite des Retikels 1 wie im Beispiel eingesetzt.

Die Pellicles 13, 14 aus Fluoridkristall sind auch vorteilhaft in Verbindung mit Retikels aus anderem Material, mit oder ohne Fluidkühlung.

Die Fertigung geht vorzugsweise von 111-orientierten Kristallplatten aus, die klassisch und/oder mit Ionenstrahl poliert werden.

Das erfindungsgemäße Retikel, das Pellicle und das System eignen sich auch für eine Kontaktbelichtungsanlage.

Auch ohne die radiale Polarisation des Beleuchtungs-Lichtbündels ist das erfindungsgemäße Retikel brauchbar. Wenn zirkulare Polarisation des Lichts eingeführt wird sind alle Effekte der Doppelbrechung rotationssymmetrisch zur optischen Achse A und damit vielfach tolerierbar.

## Patentansprüche

1. Retikel mit Trägermaterial (10) aus transparentem optisch einachsigem Kristall, dadurch gekennzeichnet, daß die Hauptachse (A) des Kristalls nahezu senkrecht zur Fläche des Retikels (1) steht.

2. Retikel aufbauend auf MgF₂ als Trägermaterial (10), dadurch gekennzeichnet, daß die Hauptachse (A) des MgF₂ nahezu senkrecht zur Retikel-Fläche (1) orientiert ist.

3. Retikel nach Anspruch 1 oder Anspruch 2, dadurch gekennzeichnet, daß die Hauptachse mit ± 5° senkrecht zur Fläche des Retikels (1) orientiert ist.

4. Retikel nach mindestens einem der Ansprüche 1-3, dadurch gekennzeichnet, daß es mit einer Kühlvorrichtung (5, 13, 14, 50, 51, 52) versehen ist.

5. Retikel nach Anspruch 4, dadurch gekennzeichnet, daß die Kühlvorrichtung (5, 13, 14, 50, 51, 52) ein strömendes Fluid (50) aufweist.

6. Belichtungsanlage der Mikrolithographie mit einem Beleuchtungssystem (2) und einem Retikel (1) mit Magnesiumfluorid als Trägermaterial (10), dadurch gekennzeichnet, daß das Beleuchtungssystem (2) radial polarisiertes Licht (20, P_{L}, P_{R}) bereitstellt und das Magnesiumfluorid mit seiner Kristall-Hauptachse nahezu in Richtung der optischen Achse (A) am Retikel (1) orientiert ist.

7. Belichtungsanlage der Mikrolithographie mit einem Beleuchtungssystem (2), einem Retikel (1) mit Trägermaterial (10) aus transparentem optisch einachsigem Kristall, dadurch gekennzeichnet, daß das Beleuchtungssystem radial polarisiertes Licht (20, P_{L}, P_{R}) bereitstellt und das Trägermaterial (10) mit seiner Hauptachse nahezu in Richtung der optischen Achse (A) am Retikel (1) orientiert ist.

8. Belichtungsanlage nach Anspruch 6 oder 7 mit einem Retikel nach mindestens einem der Ansprüche 3-5.

9. Retikel (1) mit Trägermaterial (10) aus Kristall, gekennzeichnet durch eine Fluidkühlung.

10. Retikel (1) nach Anspruch 9, dadurch gekennzeichnet, daß mindestens eine Planplatte (13, 14) parallel am Retikel (1) angeordnet ist und zwischen Retikel (1) und Planplatte (13, 14) ein Fluid (50) strömt.

11. Retikel (1) nach Anspruch 10, dadurch gekennzeichnet, daß die Planplatte (13, 14) aus Kristall, insbesondere CaF₂ oder MgF₂ besteht.

12. Pellicle (13, 14) aus Fluoridkristall, insbesondere CaF₂, BaF₂ oder MgF₂.
